# EUROPEAN PATENT SPECIFICATION

(11) **EP 0 786 839 B1**
(45) Date of publication and mention of the grant of the patent: **23.04.2003**
(21) Application number: 96307694.8
(22) Date of filing: 24.10.1996
(51) Int. Cl.: H01S 5/10, H01S 5/02, G11B 7/125

(54) **Light output apparatus and optical pickup apparatus employing the same**
Lichtquelle und optisches Abtastgerät
Dispositif à l'émission de lumière et appareil de lecture optique

(30) Priority: 23.01.1996 KR 9601396
(43) Date of publication of application: 30.07.1997
(73) Proprietor: Samsung Electronics Co., Ltd., Suwon City, Kyungki-do (KR)
(72) Inventor: Shin, Hyun-kuk, Suwon-city, Kyungki-do (KR)
(74) Representative: Chugg, David John

(56) References cited:
- GB-A- 2 289 974
- US-A- 5 448 536
- PATENT ABSTRACTS OF JAPAN vol. 010, no. 125 (E-402), 10 May 1986 & JP 60 257584 A (SHARP KK), 19 December 1985,
- PATENT ABSTRACTS OF JAPAN vol. 018, no. 570 (E-1623), 31 October 1994 & JP 06 209138 A (SEIKO EPSON CORP), 26 July 1994,
- PATENT ABSTRACTS OF JAPAN vol. 009, no. 234 (E-344), 20 September 1985 & JP 60 088486 A (MATSUSHITA DENKI SANGYO KK), 18 May 1985,
- PATENT ABSTRACTS OF JAPAN vol. 016, no. 035 (P-1304), 28 January 1992 & JP 03 242838 A (MATSUSHITA ELECTRIC IND CO LTD), 29 October 1991,
- PATENT ABSTRACTS OF JAPAN vol. 017, no. 132 (P-1504), 18 March 1993 & JP 04 311828 A (HITACHI LTD), 4 November 1992,
- INTERNATIONAL CONFERENCE ON SOLID STATE DEVICES AND MATERIALS, 1 August 1992, pages 595-597, XP000312274 HIDEO KOSAKA ET AL: "PIXELS CONSISTING OF DOUBLE VERTICAL-CAVITY DETECTOR AND SINGLE VERTICAL-CAVITY LASER SECTIONS FOR 2-D BIDIRECTIONAL OPTICAL INTERCONNECTIONS"
- PATENT ABSTRACTS OF JAPAN vol. 016, no. 535 (E-1288) 05 November 1992 & JP 04 199 890 A (MITSUBISHI ELECTRIC CORP) 21 July 1992
- PATENT ABSTRACTS OF JAPAN vol. 018, no. 577 (E-1625) 04 November 1994 & JP 06 216 406 A (SONY CORP) 05 August 1994

## Description

The present invention relates to a light output apparatus and an optical pickup apparatus employing the same, and more particularly, to a light output apparatus and an optical pickup apparatus employing the same, capable of controlling the quantity of light emitted from a vertical cavity surface emitting laser (VCSEL).

Generally, the VCSEL which can be used as a light source is formed of a first reflector stack, an active region, a second reflector stack, and an electrode layer stacked one on top of the other. The first reflector stack is formed of at least one n-type semiconductor material and the second reflector stack is formed of at least one p-type semiconductor material. The active region generates a laser beam during application of a forward biased voltage to the electrode layer. This laser beam is resonated between the first and second reflector stacks and emitted in a direction perpendicular to the surface of the stack. Therefore, light emitted from the VCSEL, having characteristics of being almost circular and highly dense and, operating in a single mode, is widely used in optical applications such as optical pickup apparatuses and computers.

However, it is hard to install a monitoring photodetector to receive some of the light emitted from the VCSEL for controlling light output, because it emits light in a vertical direction to the upper surface thereof and because the lower surface thereof is mounted on a semiconductor base.

To solve this problem, the prior art entitled Feedback Mechanism for vertical Cavity Surface Emitting Lasers is provided in U.S. Patent No. 5,285,466. This mechanism, described with reference to Figures 1 and 2, includes a VCSEL 12 which emits light when a forward biased voltage is applied and a ring patterned monitoring photodetector 14 installed around the VCSEL 12 to receive light emitted horizontally from the VCSEL 12. This monitoring photodetector 14 has a stack structure which is identical or similar to that of the VCSEL 12 and receives light, when a reverse biased voltage or no bias is applied to the electrode layer formed on the respective upper and lower surfaces.

The monitoring photodetector 14 controls the quantity of light emitted from the VCSEL 12 by receiving horizontally emitted light emitted therefrom and then, converting it into an electrical signal and feeding it back to the electrode of the VCSEL 12.

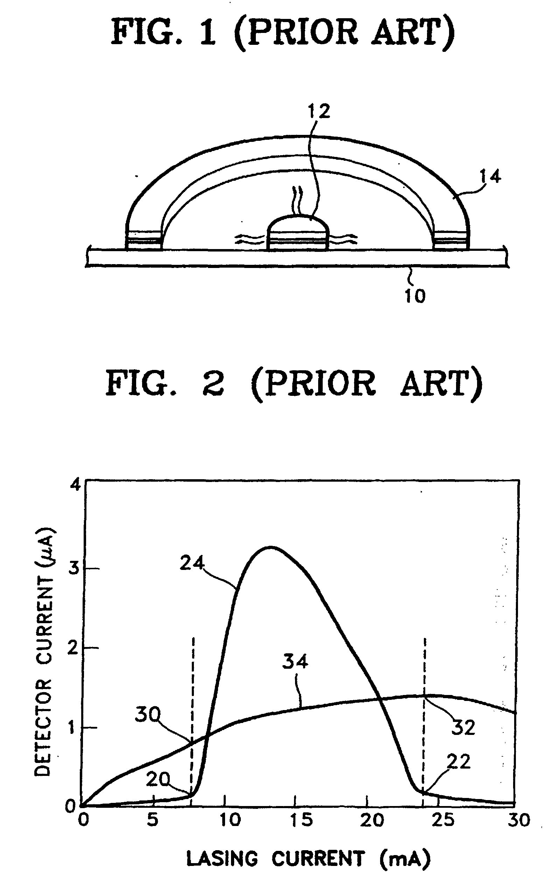

Light vertically emitted from the VCSEL 12 is generated by forward biased lasing currents in the mA range. As shown in Figure 2, the currents 24 due to the vertically emitted light detected by the monitoring photodetector 14 has a lasing threshold point 20 where the quantity of light is sharply increased and a lacing termination point 22 where the quantity of light is sharply decreased. When the lasing currents between the lasing threshold 20 and lasing termination point 22 are applied, output currents of several microamperes are detected. When the lasing currents outside the range are applied, the currents detected from the monitoring photodetector 14 are negligible.

The currents 34 due to horizontally emitted light are relatively small compared to those 24 due to vertically emitted light. Also, the lasing threshold point 30 and lasing termination point 32 of the currents due to horizontally emitted light 34 are not clearly defined. The currents 34 due to horizontally emitted light are increased slowly and then, decreased.

Here, the fact that the detected currents due to horizontally emitted light are not proportionate to those due to vertically emitted light means that the quantity of horizontally emitted light is not proportionate to that of vertically emitted light. Therefore, it is impossible to precisely control the quantity of vertically emitted light based on the detected horizontally emitted light. Also, since much horizontally emitted light is transmitted through the monitoring photodetector 14, it is difficult to obtain a sufficient amount of the horizontally emitted light necessary to detect a signal for controlling the amount of vertically emitted light.

Patent abstracts of Japan, Volume 16, No. 535(E-1288), November 1972 and JP-A-4199890 discloses a semiconductor laser device having a monitoring photodiode and a signal reproducing photodiode formed in the same flat plane of a sub-mounting using a surface emission type laser diode.

Patent abstracts of Japan, Volume 18, No. 577(E-1625), November 1994 and JP-A-6216406 discloses an optical transmitter in which output rays from a light emitting device are output to the outside of a package through a transparent cap. A part of the output rays is partially reflected by the package and the partially reflected rays are projected to a plurality of convex lenses for detection.

US 5448536 discloses an optical head having a laser source unit, a photodetector and detraction grating.

It is an aim of embodiments of the present invention to provide a light output apparatus and an optical pickup apparatus employing the same capable of effectively controlling the quantity of light emitted from a VCSEL on the basis of the quantity of vertically emitted light.

According to one aspect of the invention as defined in claim 1, there is provided a light output apparatus, comprising a base, a VCSEL, installed on the base, for emitting light in a direction normal to the base, and light output controlling means for controlling the light output of the VCSEL, wherein the light output controlling means is comprised of a housing formed to enclose the VCSEL having a projector window for transmitting most of the light emitted from the VCSEL and reflecting some of the light back onto the base, a monitoring photodetector, installed on the same surface of the base whereon the VCSEL is installed, for receiving some of the light emitted from the VCSEL and reflected from the projector window and converting the light into an electrical signal, and a plurality of lead pins, connected to the VCSEL and the monitoring photodetector, for connecting to a power supply and transmitting the electrical signal, the light output apparatus being characterised in that the monitoring photodetector has an identical structure to that of the VCSEL, functions to receive incident light by being reverse biased and forms part of the light output controlling means for monitoring and controlling the light output of the VCSE, the apparatus being further characterised in that a predetermined portion of the inner surface of the projector window has a reflective coating formed upon it to increase the quantity of light reflected from the projector window to the monitoring photodetector.

According to a second aspect of the invention as defined in claim 2, there is provided an optical pickup apparatus employing a light output apparatus, comprising a base, a VCSEL, installed on the base, for emitting light in a direction normal to the base, light output controlling means for controlling the light output of the VCSEL, an object lens for forming a light spot on an optical recording medium by collecting light emitted from the VCSEL, a light path changing means for changing the path of light reflected from the optical recording medium, and a first photodetector for receiving the reflected light and detecting an error signal and an information signal, wherein the light output controlling means comprise a housing formed to enclose the VCSEL having a projector window for transmitting most of the light emitted from the VCSEL and reflecting some of the light back onto said base, a monitoring photodetector for monitoring, for receiving some of the light emitted from the VCSEL and reflected from the projector window and converting the received light into an electrical signal, and a plurality of first lead pins, connected to the VCSEL and the monitoring photodetector, for connecting to a power supply and transmitting the electrical signal, the optical pickup apparatus being characterised in that the monitoring photodetector is installed on the base whereon the VCSEL is installed and has an identical structure to that of the VCSEL, functions to receive incident light by being reverse biased and forms part of the light output controlling means for monitoring and controlling the light output of the VCSEL, the apparatus being further characterised in that a predetermined portion of the inner surface of the projector window has a reflective coating formed upon it to increase the quantity of light reflected from the projector window to the monitoring photodetector.

Preferably, the reflective coating is formed of Au or Ag.

Preferably, said first photodetector is arranged on the base whereon said VCSEL is arranged.

Said first photodetector may comprise four separate photodetectors for independently receiving light and converting said received light into electrical signals.

The apparatus may further comprise at least one second lead pin, electrically connected to said first photodetector, for transmitting electrical signals.

Preferably, there is provided a hologram device for diffracting and collecting light reflected from the optical recording medium and then, directing it to the first photodetector is installed in the light path between said projector window and said object lens as said light path changing means.

A predetermined hologram pattern may be provided for diffracting and collecting light reflected from the optical recording medium and directing it to the first photodetector is formed on an upper surface of the projector window as said light path changing means.

For a better understanding of the invention, and to show how embodiments of the same may be carried into effect, reference will now be made, by way of example, to the accompanying diagrammatic drawings, in which:
Figure 1 is a schematic view of a conventional light output apparatus;
Figure 2 is a graph showing detected currents due to with respect to vertically and horizontally emitted light output from the light output apparatus of Figure 1;
Figure 3 is a schematic sectional view of an embodiment of light output apparatus incorporating some features of the present invention;
Figure 4 is a schematic sectional view of a first embodiment of the light output apparatus according to the present invention;
Figure 5 is a schematic sectional view of an embodiment of an optical pickup apparatus employing incorporating some features of the light output apparatus the present invention;
Figure 6 is a partially cutaway plan view showing the interior of the housing of the optical pickup apparatus shown in Figure 5;
Figure 7 is a schematic sectional view showing an embodiment of the optical pickup apparatus employing the light output apparatus according to the present invention;
Figure 8 is a schematic sectional view showing an embodiment of an optical pickup apparatus employing optical pickup apparatus which incorporates some of the features of the present invention; and
Figure 9 is a schematic sectional view showing an embodiment of the optical pickup apparatus employing the light output apparatus according to the present invention.

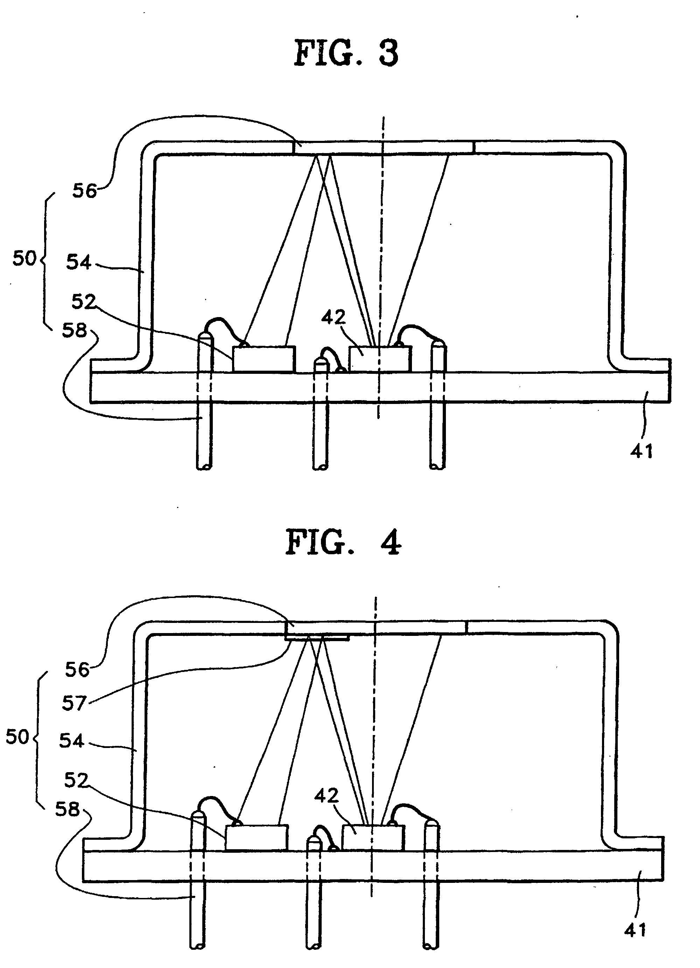

A light output apparatus is shown in Figure 3 comprising a base 41, a VCSEL 42 formed on the base 41, and a light output controller 50 for controlling the light output of the VCSEL 42.

The VCSEL 42 emits light in a direction perpendicular to the upper surface thereof.

The light output controller 50 is comprised of a monitoring photodetector 52, a housing 54 having a projector window 56, and a plurality of lead pins 58.

The housing 54 is installed on the base 41 to enclose the VCSEL 42 and the monitoring photodetector 52. The projector window 56 is installed in the path of light emitted from the VCSEL 42. Most of the light emitted from the VCSEL 42 is transmitted through the projector window 56 and the rest is reflected off the projector window 56.

The monitoring photodetector 52, installed on the base 41 whereon the VCSEL 42 is installed, receives light reflected from the projector window 56. At this time, since the monitoring photodetector 52 receives some of the vertical light, the quantity of the received light is proportionate to that of the light emitted from the VCSEL 42.

The monitoring photodetector 52 has the same structure as that of the VCSEL 42 and is able to receive incident light by being reverse biased.

The lead pins 58 connect an external power source to the VCSEL 42 and the monitoring photodetector 52 and, transmit electrical signals detected from the monitoring photodetector 52 outward. These lead pins 58 pass through the base 41 and are connected to the monitoring photodetector 52, the VCSEL 42, and the base 41 in the housing 54.

Figure 4 is a sectional view showing an embodiment of the light output apparatus according to the present invention.

Here, the reference numerals identical to those of Figure 3, indicate similar or identical portions having similar or identical functions.

As shown in Figure 4, a reflective coating 57 is formed on a predetermined portion of the projector window 56 to increase the quantity of light reflected from the projector window 56 to the monitoring photodetector 52.

This reflective coating 57 is formed of a highly reflective metal, namely, Au or Ag, etc.

The projector window 56 without the reflective coating 57 reflects about 5 to 6% of the light emitted from the VCSEL 42 and about 50 to 60% with the reflective coating. Therefore, enough light can be received by the monitoring photodetector 52 to generate electrical signals for controlling light output of the VCSEL 42.

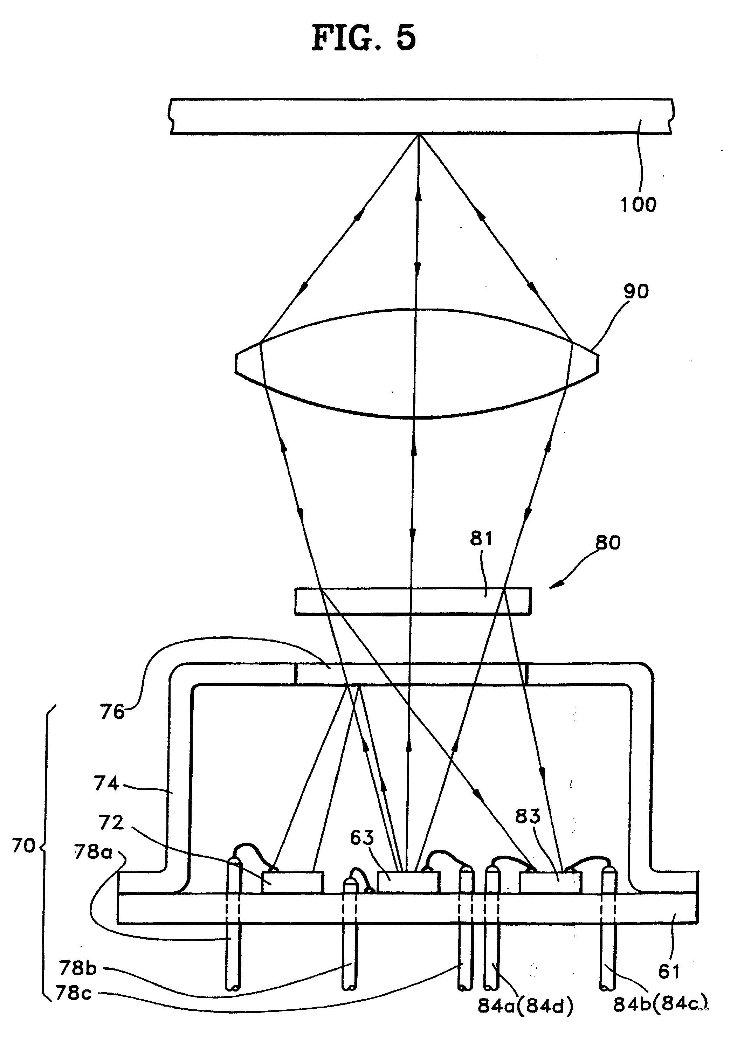

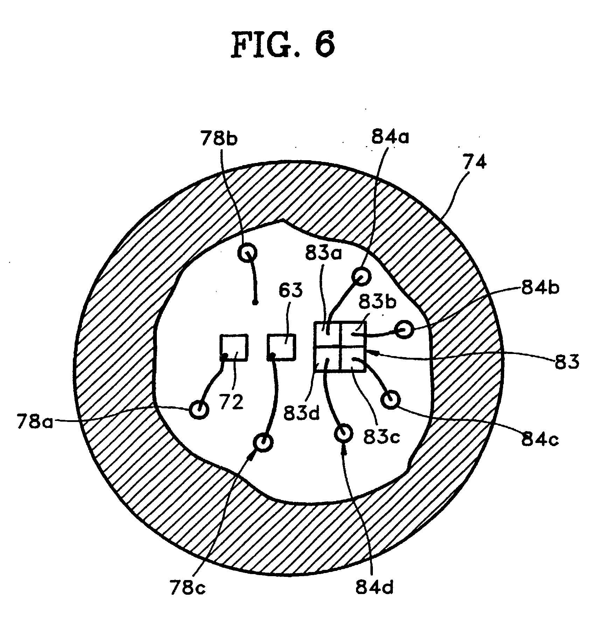

Now, an optical pickup apparatus employing some features of the light output apparatus according to the present invention, with reference to Figures 5 and 6 will be described.

As shown in Figure 5 an optical pickup apparatus is comprised of a base 61, a VCSEL 63, formed on the base 61, for emitting a laser beam, a light output controller 70 for controlling light output of the VCSEL 63, an object lens 90, arranged on an optical axis between the VCSEL 63 and an optical recording medium 100, for collecting an incident beam and concentrating the light on the optical recording medium 100, a first photodetector 83 for receiving light reflected from the optical recording medium 100 and detecting an information signal and an error signal, and a light path changing portion 80 for directing the light reflected from the optical recording medium 100 to the first photodetector 83.

The light output controller 70 is comprised of a second monitoring photodetector 72, a housing 74 having a projector window 76, and first lead pins 78a, 78b, and 78c.

Here, the operations of the VCSEL 63 and the light output controller 70 are the same as mentioned above.

The first photodetector 83 is installed on the base 61 whereon the VCSEL 63 is installed.

This first photodetector 83 preferably comprises four separate photodetectors 83a, 83b, 83c, and 83d (shown in Figure 6) for independently receiving light and converting it into electrical signals. Four second lead pins 84a, 84b, 84c, and 84d installed inside of the housing 74 pass through the base 61 and transmit the electrical signals detected from the first photodetector 83 out of the housing 74. The second lead pins 84a, 84b, 84c, and 84d are electrically connected to the four separate photodetectors 83a, 83b, 83c, and 83d of the first photodetector 83, respectively and an error detection circuit portion (not shown) for detecting radio frequency signals, tracking error signals, and focus error signals.

The light path changing portion 80 is arranged in the light path between the projector window 76 and the object lens 90 and, preferably has a hologram device 81 for diffracting and collecting light reflected from the optical recording medium 100 and then, directing it to the first photodetector 83. The light path changing portion 80 may be a common beam splitter. In this case, the first photodetector 83 is installed outside of the housing 74.

Here, the first photodetector 83 is comprised of four separate photodetectors but can be comprised of another suitable number of photodetectors, such as two or six, as occasion demands.

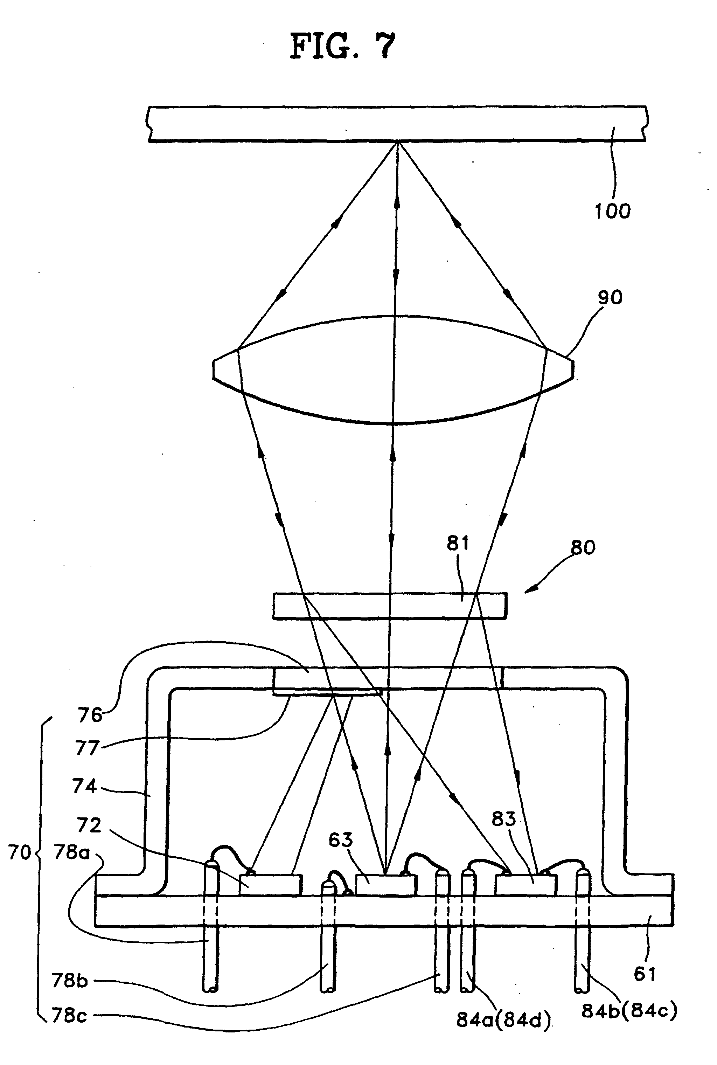

An embodiment of the optical pickup apparatus employing the light output apparatus according to the present invention will now be described with reference to Figure 7.

As shown, a reflective coating 77 is formed on a predetermined portion of a projector window 76 to increase the quantity of light reflected from the projector window 76 to a second monitoring photodetector 72.

Generally, this reflective coating 77 is formed of a highly reflective metal, namely, Au or Ag, etc. Here, the portions which are not described are similar or identical to the portions having the identical reference numerals described in the arrangements referred to in Figures 5 and 6.

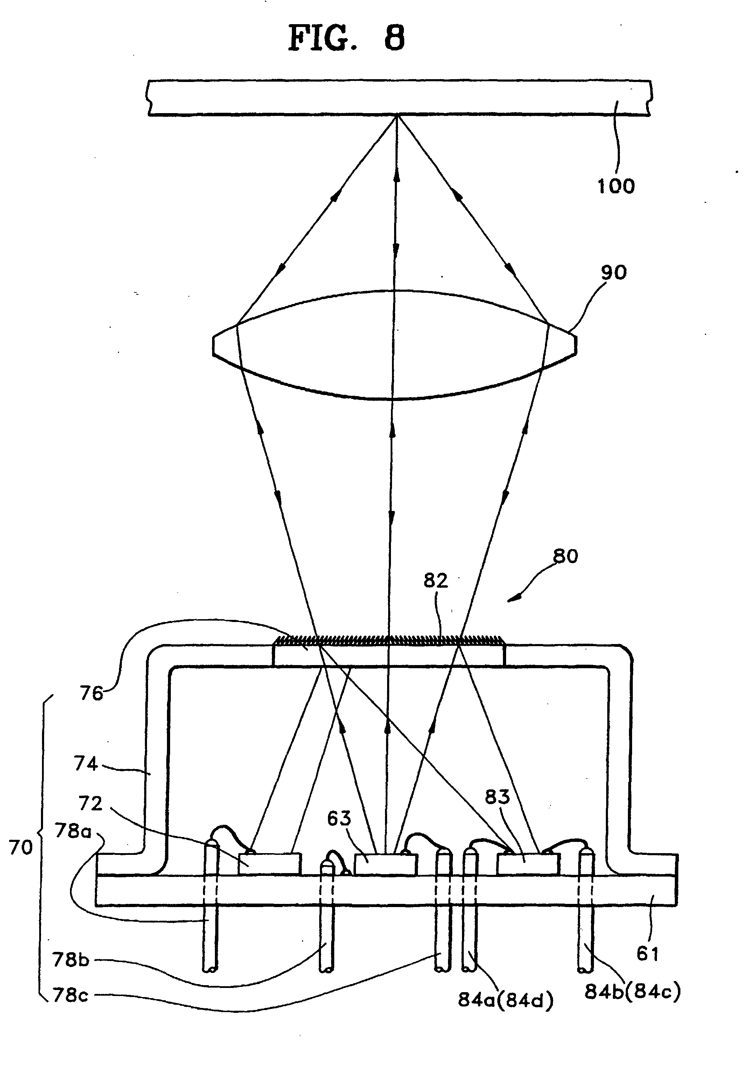

An embodiment of an optical pickup apparatus employing the light output apparatus incorporating some of the features of the present invention will now be described with reference to Figure 8.

As shown, a hologram pattern 82 is formed on an upper surface of a projector window 76 as a light path changing portion 80. The hologram pattern 82 diffracts light reflected from the optical recording medium 100 and concentrates it on the first photodetector 83 formed on the base 61.

The optical pickup apparatus can be made more compact by forming a hologram pattern 82 on the upper surface of the projector window 76 than by employing a hologram device 81 (shown in Figure 7) separately as a light path changing portion 80.

The portions which are not described are similar or identical to the portions having the identical reference numerals described with reference to Figures 5 and 6.

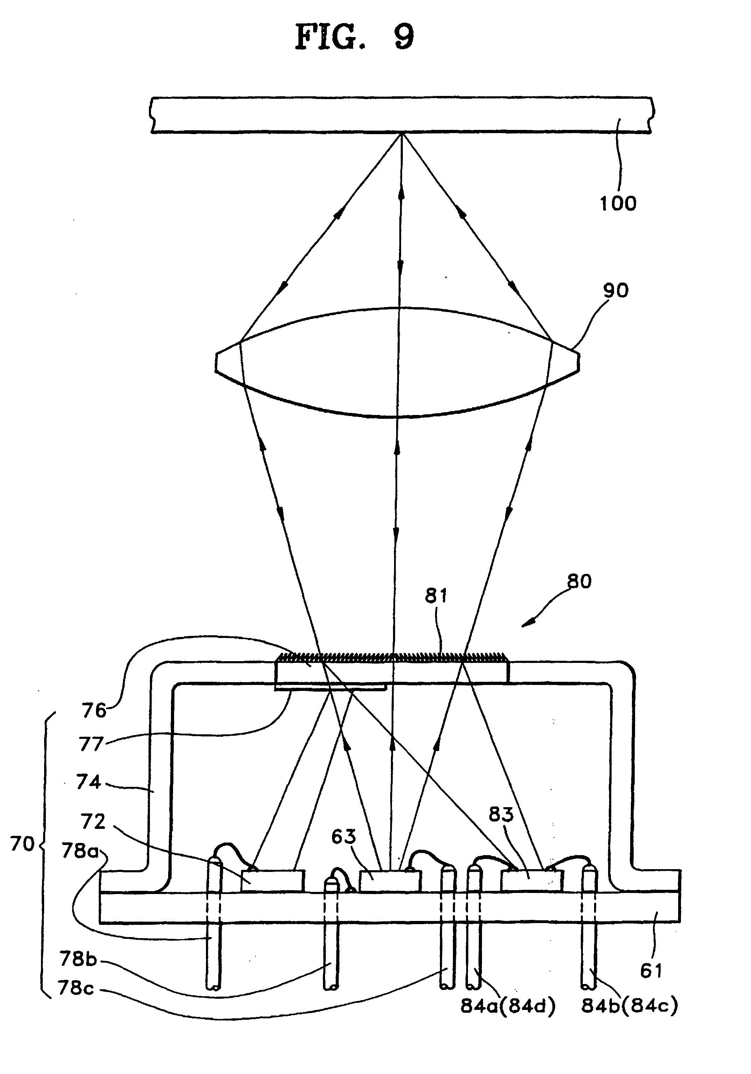

An embodiment of the optical pickup apparatus employing the light output apparatus according to the present invention with reference to Figure 9 will now be described.

As shown, a reflective coating 77 of the type shown in Figure 7 is formed on a predetermined portion of an inner surface of a projector window 76 to increase the quantity of light reflected from the projector window 76 to a second monitoring photodetector 72. Also, a hologram pattern of the type shown in Figure 8 is formed on an upper surface of the projector window 76. The functions and operations of the reflective coating 77 and hologram pattern 82 are the same as described above.

The portions which are not described are similar or identical to the portions having the identical reference numerals described with reference to Figures 5 to 8.

As described above, the light output apparatus of embodiments according to the present invention detects some of the vertically emitted light emitted from the VCSEL 63 with a monitoring photodetector and controls the light output more precisely based on the detected light.

Furthermore, the optical pickup apparatus employing the light output apparatus according to the present invention can control the quantity of light emitted from the VCSEL 63 precisely by receiving light proportionate to the quantity of light emitted from the VCSEL 63. Also, it may be easy to assemble and may have a compact structure through forming the hologram device on the projector window of the housing.

## Claims

1. A light output apparatus, comprising:
a base (41, 61);
a vertical cavity surface emitting laser (VCSEL) (42, 63), installed on the base, for emitting light in a direction normal to the base (41, 61); and
light output controlling means (50, 70) for controlling the light output of the VCSEL,
wherein said light output controlling means is comprised of a housing (54, 74) formed to enclose the VCSEL (42, 63) having a projector window (56, 76) for transmitting most of the light emitted from the VCSEL (42, 63) and reflecting some of the light back onto said base (41, 61), a monitoring photodetector (52, 72), installed on the same surface of the base (41, 61) whereon the VCSEL (42, 63) is installed, for receiving some of the light emitted from the VCSEL (42, 63) and reflected from the projector window (56, 76) and converting the light into an electrical signal, and a plurality of lead pins (58, 78), connected to the VCSEL (42, 63) and the monitoring photodetector (52, 72), for connecting to a power supply and transmitting the electrical signal, the light output apparatus being **characterised in that** the monitoring photodetector (52, 72) has an identical structure to that of the VCSEL (42, 63), functions to receive incident light by being reverse biased and forms part of the light output controlling means for monitoring and controlling the light output of the VCSEL (42, 63), the apparatus being further **characterised in that** a predetermined portion of the inner surface of the projector window has a reflective coating formed upon it to increase the quantity of light reflected from the projector window to the monitoring photodetector

2. An optical pickup apparatus, comprising:
a base (41, 61);
a VCSEL (63), installed on the base, for emitting light in a direction normal to the base (61);
light output controlling means (70) for controlling the light output of the VCSEL (63);
an object lens (90) for concentrating light on an optical recording medium (100) by collecting light emitted from the VCSEL (62);
a light path changing means (80, 81) for changing the path of light reflected from the optical recording medium (100); and
a first photodetector (83) for receiving said reflected light and detecting an error signal and an information signal,
wherein said light output controlling means (70) comprise a housing (74) formed to enclose the VCSEL (63) having a projector window (76) for transmitting most of the light emitted from the VCSEL (63) and reflecting some of the light back onto said base (61), a monitoring photodetector (72), for receiving some of the light emitted from the VCSEL (63) and reflected from the projector window (76) and converting the light into an electrical signal, and a plurality of first lead pins (78), connected to the VCSEL (63) and the monitoring photodetector (72), for connecting to a power supply and transmitting the electrical signal, the optical' pickup apparatus being **characterised in that** the monitoring photodetector (52, 72) has an identical structure to that of the VCSEL (42, 63), functions to receive incident light by being reverse biased and forms part of the light output controlling means for monitoring and controlling the light output of the VCSEL (42, 63), the apparatus being further **characterised in that** a predetermined portion of the inner surface of the projector window has a reflective coating formed upon it to increase the quantity of light reflected from the projector window to the monitoring photodecector.

3. An optical pickup apparatus as claimed in claim 1 or 2, wherein said first photodetector (83) is arranged on the base whereon said VCSEL (63) is arranged.

4. An optical pickup apparatus as claimed in claim 1, 2 or 3, wherein said first photodetector (83) comprises four separate photodetectors (83a - 83d) for independently receiving light and converting said received light into electrical signals.

5. An optical pickup apparatus as claimed in any of claims 2 to 4 further comprising at least one second lead pin (84), electrically connected to said first photodetector (83), for transmitting electrical signals.

6. An optical pickup apparatus as claimed in any of claims 2 to 5, wherein a hologram device (81) for diffracting and collecting light reflected from the optical recording medium (100) and then, directing it to the first photodetector (83) is installed in the light path between said projector window (76) and said object lens (90) as said light path changing means.

7. An optical pickup apparatus as claimed in any of claims 2 to 6, wherein a predetermined hologram pattern (81) for diffracting and collecting light reflected from the optical recording medium and directing it to the first photodetector (83) is formed on an upper surface of the projector window (76) as said light path changing means.

8. An optical pickup apparatus as claimed in any preceding claim, wherein the reflective coating (77) is formed of Au or Ag.

## Patentansprüche

1. Lichtausgabevorrichtung, die umfasst:
einen Untersatz (41, 61);
einen Vertikalhohlraum-Flächenemissionslaser (VCSEL) (42, 63), der auf dem Untersatz installiert ist, um Licht in einer Richtung senkrecht zu dem Untersatz (41, 61) zu emittieren; und
eine Lichtausgabe-Steuereinrichtung (50, 70), die die Lichtausgabe des VCSEL steuert,
wobei die Lichtausgabe-Steuereinrichtung aus einem Gehäuse (54, 74), das so geformt ist, dass es den VCSEL (42, 63) umschließt, und das ein Projektorfenster (56, 76) aufweist, das den Großteil des Lichtes, das von dem VCSEL (42, 63) emittiert wird, durchlässt und einen Teil des Lichtes auf den Untersatz (41, 61) zurückflektiert, einem überwachenden Fotodetektor (52, 72), der an der gleichen Fläche des Untersatzes (41, 61) installiert ist, an der der VCSEL (42, 63) installiert ist, und einen Teil des Lichtes, das von dem VCSEL (42, 63) emittiert und von dem Projektorfenster (56, 76) reflektiert wird, empfängt und das Licht in ein elektrisches Signal umwandelt, sowie einer Vielzahl von Zuleitungsstiften (58, 78) besteht, die mit dem VCSEL (42, 63) und dem überwachenden Fotodetektor (52, 72) verbunden sind, um Verbindung zu einer Stromquelle herzustellen und das elektrische Signal zu übertragen, wobei die Lichtausgabevorrichtung **dadurch gekennzeichnet ist, dass** der überwachende Fotodetektor (52, 72) einen zu dem VCSEL (42, 63) identischen Aufbau hat, dazu dient, auftreffendes Licht zu empfangen, indem er in Sperrrichtung betrieben wird, und einen Teil der Lichtausgabe-Steuereinrichtung zum Überwachen und Steuern der Lichtausgabe des VCSEL (42, 63) bildet, wobei die Vorrichtung des weiteren **dadurch gekennzeichnet ist, dass** auf einem vorgegebenen Abschnitt der Innenfläche des Projektorfenster eine reflektierende Beschichtung ausgebildet ist, um die Menge an Licht zu erhöhen, die von dem Projektorfenster zu dem überwachenden Fotodetektor reflektiert wird.

2. Optische Aufnehmervorrichtung, die umfasst:
einen Untersatz (41, 61);
einen VCSEL (63), der auf dem Untersatz installiert ist und Licht in einer Richtung senkrecht zu dem Untersatz (61) emittiert;
eine Lichtausgabe-Steuereinrichtung (70), die die Lichtausgabe des VCSEL (63) steuert;
eine Objektivlinse (90), die Licht auf ein optisches Aufzeichnungsmedium (100) konzentriert, indem sie von dem VCSEL (62) emittiertes Licht sammelt;
eine Lichtweg-Änderungseinrichtung (80, 81), die den Weg von Licht, das von dem optischen Aufzeichnungsmedium (100) reflektiert wird, ändert; und
einen ersten Fotodetektor (83), der das reflektierte Licht empfängt und ein Fehlersignal sowie ein Informationssignal erfasst,
wobei die Lichtausgabe-Steuereinrichtung (70) ein Gehäuse (74), das so geformt ist, dass es den VCSEL (63) umschließt, und das ein Projektorfenster (76) umfasst, das den Großteil des Lichtes, das von dem VCSEL (63) emittiert wird, durchlässt und einen Teil des Lichtes auf den Untersatz (61) zurückreflektiert, einen überwachenden Fotodetektor (72), der einen Teil des Lichtes, das von dem VCSEL (63) emittiert und von dem Projektorfenster (76) reflektiert wird, empfängt und das Licht in ein elektrisches Signal umwandelt, sowie eine Vielzahl erster Zuleitungsstifte (78) umfasst, die mit dem VCSEL (63) und dem überwachenden Fotodetektor (72) verbunden sind, um Verbindung zu einer Stromquelle herzustellen und das elektrische Signal zu übertragen, wobei die optische Aufnehmervorrichtung **dadurch gekennzeichnet ist, dass** der überwachende Fotodetektor (52, 72) einen zu dem des VCSEL (42, 63) identischen Aufbau hat, dazu dient, auftreffendes Licht zu empfangen, indem er in Sperrrichtung betrieben wird, und einen Teil der Lichtausgabe-Steuereinrichtung zum Überwachen und Steuern der Lichtausgabe des VCSEL (42, 63) bildet, wobei die Vorrichtung des weiteren **dadurch gekennzeichnet ist, dass** auf einem vorgegebenen Abschnitt der Innenfläche des Projektorfensters eine reflektierende Beschichtung ausgebildet ist, um die Menge an Licht zu erhöhen, die von dem Projektorfenster zu dem überwachenden Fotodetektor reflektiert wird.

3. Optische Aufnehmervorrichtung nach Anspruch 1 oder 2, wobei der erste Fotodetektor (83) auf dem Untersatz angeordnet ist, auf dem der VCSEL (63) angeordnet ist.

4. Optische Aufnehmervorrichtung nach Anspruch 1, 2 oder 3, wobei der erste Fotodetektor (83) vier separate Fotodetektoren (83a - 83d) umfasst, die unabhängig Licht empfangen und das empfangene Licht in elektrische Signale umwandeln.

5. Optische Aufnehmervorrichtung nach einem der Ansprüche 2 bis 4, die des weiteren wenigstens einen zweiten Zuleitungsstift (84) umfasst, der elektrisch mit dem ersten Fotodetektor (83) verbunden ist, um elektrische Signale zu übertragen.

6. Optische Aufnehmervorrichtung nach einem der Ansprüche 2 bis 5, wobei eine Hologrammvorrichtung (81), die von dem optischen Aufzeichnungsmedium (100) reflektiertes Licht beugt und sammelt und es dann zu dem ersten Fotodetektor (83) leitet, auf dem Lichtweg zwischen dem Projektorfenster (76) und der Objektivlinse (90) als die Lichtweg-Änderungseinrichtung installiert ist.

7. Optische Aufnehmervorrichtung nach einem der Ansprüche 2 bis 6, wobei eine vorgegebene Hologrammstruktur (81), die von dem optischen Aufzeichnungsmedium reflektiertes Licht beugt und sammelt und es zu dem ersten Fotodetektor (83) leitet, an einer Oberseite des Projektorfensters (76) als die Lichtweg-Änderungseinrichtung ausgebildet ist.

8. Optische Aufnehmervorrichtung nach einem der vorangehenden Ansprüche, wobei die reflektierende Beschichtung (77) aus Au oder Ag besteht.

## Revendications

1. Dispositif d'émission de lumière, comprenant :
une embase (41, 61) ;
un laser à émission de surface à cavité verticale (VCSEL) (42, 63), installé sur l'embase, pour émettre de la lumière dans une direction perpendiculaire à l'embase (41, 61); et
un moyen de commande (50, 70) d'émission de lumière pour commander l'émission de lumière du VCSEL,
dans lequel ledit moyen de commande d'émission de lumière est constitué par un boîtier (54, 74) formé pour contenir le VCSEL (42, 63) ayant une fenêtre de projection (56, 76) pour transmettre la majeure partie de la lumière émise par le VCSEL (42, 63) et réfléchir vers ladite embase (41, 61) une partie de la lumière, un photodétecteur de contrôle (52, 72), installé sur la même surface de l'embase (41, 61) que celle sur laquelle est installé le VCSEL (42, 63), pour recevoir une partie de la lumière émise par le VCSEL (42, 63) et réfléchie depuis la fenêtre de projection (56, 76) et convertir la lumière en signal électrique, et une pluralité de broches de connexion (58, 78), connectées au VCSEL (42, 63) et au photodétecteur de contrôle (52, 72), pour la connexion avec une source d'alimentation électrique et l'émission du signal électrique, le dispositif d'émission de lumière étant **caractérisé en ce que** le photodétecteur de contrôle (52, 72) a une structure identique à celle du VCSEL (42, 63), sert à recevoir la lumière incidente en subissant une polarisation inverse et fait partie du moyen commandant l'émission de lumière pour contrôler et commander l'émission de lumiére du VCSEL (42, 63), le dispositif étant en outre **caractérisé en ce que** sur une partie prédéterminée de la surface intérieure de la fenêtre de projection est formé un revêtement réfléchissant destiné à accroître la quantité de lumière réfléchie depuis la fenêtre de projection vers le photodétecteur de contrôle.

2. Appareil de lecture optique, comprenant :
une embase (41, 61);
un VCSEL (63) installé sur l'embase, pour émettre de la lumière dans une direction perpendiculaire à l'embase (61) ;
un moyen de commande (70) d'émission de lumière pour commander l'émission de lumière du VCSEL (63) ;
un objectif (90) pour concentrer de la lumière sur un support d'enregistrement optique (100) en interceptant la lumière émise par le VCSEL (62) ;
un moyen de modification de trajet de lumiére (80, 81) pour modifier le trajet de la lumière réfléchie par le support d'enregistrement optique (100) ; et
un premier photodétecteur (83) pour recevoir ladite lumière réfléchie et détecter un signal d'erreur et un signal d'information,
dans lequel ledit moyen de commande (70) d'émission de lumière comporte un boîtier (74) formé pour contenir le VCSEL (63) ayant une fenêtre de projection (76) pour transmettre la majeure partie de la lumière émise par le VCSEL (63) et réfléchir vers ladite embase (61) une partie de la lumière, un photodétecteur de contrôle (72) pour recevoir une partie de la lumière émise par le VCSEL (63) et réfléchie depuis la fenêtre de projection (76) et convertir la lumière en signal électrique, et une pluralité de broches de connexion (78), connectées au VCSEL (63) et au photodétecteur de contrôle (72), pour la connexion avec une source d'alimentation électrique et l'émission du signal électrique, l'appareil de lecture optique étant **caractérisé en ce que** le photodétecteur de rontrôle (52, 72) a une structure identique à celle du VCSEL (42, 63), sert à recevoir la lumière incidente en subissant une polarisation inverse et fait partie du moyen commandant l'émission de lumière pour contrôler et commander l'émission de lumiére du VCSEL (42, 63), l'appareil étant en outre **caractérisé en ce que** sur une partie prédéterminée de la surface intérieure de la fenêtre de projection est formé un revêtement réfléchissant destiné à accroître la quantité de lumière réfléchie depuis la fenêtre de projection vers le photodétecteur de contrôle.

3. Appareil de lecture optique selon la revendication 1 ou 2, dans lequel ledit premier photodétecteur (83) est disposé sur l'embase sur laquelle est disposé ledit VCSEL (63).

4. Appareil de lecture optique selon la revendication 1, 2 ou 3, dans lequel ledit premier photodétecteur (83) comporte quatre photodétecteurs séparés (83a - 83d) pour recevoir indépendamment la lumière et convertir ladite lumière reçue en signaux électriques.

5. Appareil de lecture optique selon l'une quelconque des revendications 2 à 4, comprenant en outre au moins une seconde broche de connexion (84), connectée audit premier photodétecteur (83), pour transmettre des signaux électriques.

6. Appareil de lecture optique selon l'une quelconque des revendications 2 à 5, dans lequel un dispositif (81) de production d'hologramme pour diffracter et recueillir la lumière réfléchie par le support d'enregistrement optique (100), puis pour la diriger vers le premier photodétecteur (83), est installé sur le trajet de lumière entre. ladite fenêtre de projection (76) et ledit objectif (90) en tant que moyen de modification de trajet de lumière.

7. Appareil de lecture optique selon l'une quelconque des revendications 2 à 6, dans lequel un motif holographique prédéterminé (81) pour diffracter et recueillir la lumière réfléchie par le support d'enregistrement optique et pour la diriger jusqu'au premier photodétecteur (83) est formé sur. une surface supérieure de la fenêtre de projection (76) en tant que moyen de modification de trajet de lumière.

8. Appareil de lecture optique selon l'une quelconque des revendications précédentes, dans lequel le revêtement réfléchissant (77) est en Au ou Ag.
